# EUROPEAN PATENT APPLICATION

(11) **EP 4 739 030 A1**
(43) Date of publication of application: **06.05.2026**
(21) Application number: 25207938.9
(22) Date of filing: 10.10.2025
(51) Int. Cl.: H10D 30/66, H10D 62/10, H10D 64/00, H10D 64/27

(54) **SPLIT-GATE MOSFET WITH REDUCED ON RESISTANCE**

(30) Priority: 30.10.2024 IT 202400024276
(71) Applicant: STMicroelectronics International N.V., 1228 Plan-les-Ouates, Geneva (CH)
(72) Inventor: ENEA, Vincenzo, 96100 SIRACUSA (IT)
(74) Representative: Studio Torta S.p.A.

(57) **Abstract**

Electronic device (10), comprising: a semiconductor body (12); trenches (13) within the semiconductor body (12) from a first side (12a) towards a second side (12b) of the semiconductor body (12) and terminating within the semiconductor body (12); an insulating field plate region (14) in each of said trenches (13); a conductive gate region (15) in each of said trenches (13) on the respective insulating field plate region (14), each being electrically insulated from the semiconductor body (12) by means of the respective insulating field plate region (14); a field plate region (16) in each of said trenches (13), buried in the respective insulating field plate region (14) and electrically insulated from the respective conductive gate region (15) and from the semiconductor body (12); gate interconnections (28) within the semiconductor body (12), from the first side (12a) towards the second side (12b), lateral to the trenches (13) and terminating in the semiconductor body (12), the gate interconnections (28) being of conductive material, insulated from the semiconductor body (12) and electrically connected to the conductive gate regions (15) in such a way as to electrically interconnect the conductive gate regions (15) with each other.

## Description

### TECHNICAL FIELD

The present invention relates to a split-gate MOSFET with reduced on-resistance, in particular to an electronic device with gate interconnections that increase the channel perimeter and the conduction area without the need for resizing the manufacturing process or for high lithographic resolution. Furthermore, it relates to a manufacturing process of the electronic device.

### BACKGROUND

MOSFET ("Metal-Oxide-Semiconductor Field-Effect Transistor") technology is now widely recognized as an excellent option for several applications, for example for switches in power supply management circuits.

Commercially available now for decades, vertical diffused MOSFET (VDMOS) devices have seen significant commercial spread by virtue of their improved electrical performances. However, for a long time, VDMOSFETs have had a high on-state resistance that limited their current handling capabilities.

This problem has been overcome with "trench-gate" MOSFETs. By virtue of the vertical-direction channel, these devices allow a reduction in cell pitch without negatively affecting current spread. In particular, the introduction of devices that use a field plate, insulated from the gate electrode and connected to the source potential, as an extension of the gate electrode has enabled the lateral depletion of the off-state drift region. Since the field plate is electrically insulated from the gate electrode, this structure is also known as "shielded-gate" or "split-gate" structure.

Split-gate technology offers significant advantages with respect to previous MOSFETs, for example an improved on-resistance with respect to the active area extension and reduced gate-drain capacity. In fact, the split-gate structure allows the use of high doping concentrations, leading to significant improvements in MOSFET performances.

As is known, one of the main goals in the development of split-gate power MOSFET devices is the reduction of the on-resistance.

This may be achieved in the prior art by reducing the main resistive contributions and/or by increasing the ratio between the conduction area and the channel perimeter with respect to the total area of the device.

However, since in the known solutions the elementary cell has a strip shape, the main limitation to achieve these objectives according to the known solutions is the reduction of the dimensions of the elementary cell of the MOSFET, which implies the need to resize the diffusion process and to increase the lithographic resolution to reduce the transversal dimension of the strip. As is evident, this implies significant additional costs and difficulties during the manufacturing step.

The aim of the present invention is to provide an electronic device and a manufacturing process of the electronic device which overcome the drawbacks of the prior art and which in particular achieve a significant increase in channel perimeter and conduction area without any need for resizing the process or high lithographic resolution.

### SUMMARY

According to the present invention, an electronic device and a manufacturing process of the electronic device are provided, as defined in the annexed claims which form an integral part of the present description.

### BRIEF DESCRIPTION OF THE DRAWINGS

For a better understanding of the present invention, a preferred embodiment is now described, purely by way of non-limiting example, with reference to the attached drawings, wherein:
- Figure 1 shows a schematic perspective view along two different section lines of an electronic device, according to one embodiment;
- Figures 2A-2C show top views of the electronic device of Figure 1, according to respective embodiments;
- Figure 3 shows a schematic perspective view along two different section lines of the present electronic device, according to a different embodiment;
- Figures 4A-4M show schematic perspective views along two different section lines of manufacturing steps of the electronic device of Figure 1, according to one embodiment; and
- Figures 5A-5S show schematic perspective views along two different section lines of manufacturing steps of the electronic device of Figure 3, according to a different embodiment.

In particular, the Figures are shown with reference to a triaxial Cartesian system defined by an X axis, a Y axis and a Z axis, orthogonal to each other.

In the following description, elements common to the different embodiments have been indicated with the same reference numbers.

### DETAILED DESCRIPTION OF THE INVENTION

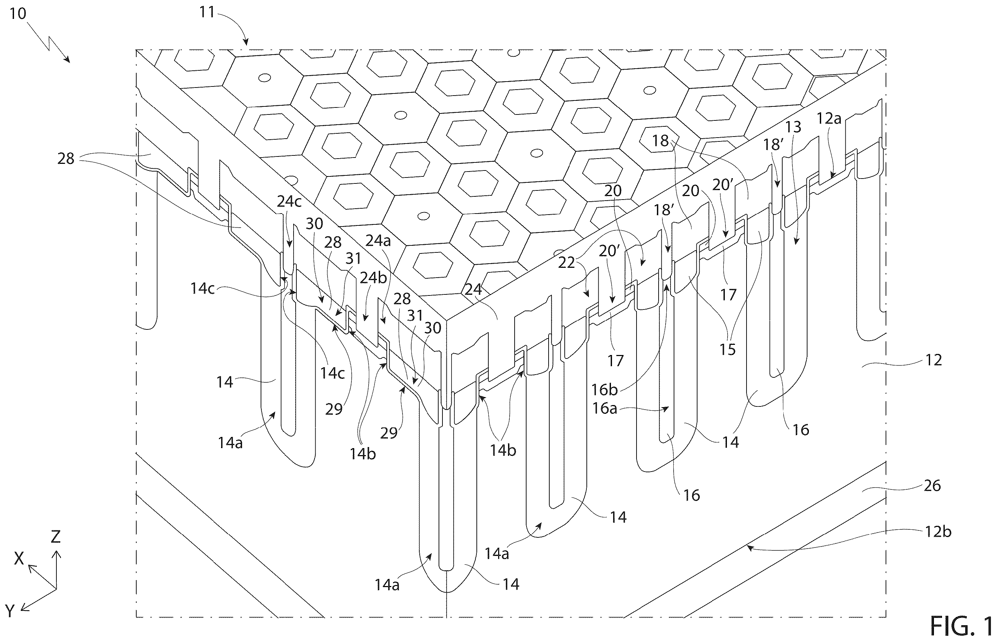

Figure 1 shows an electronic device 10, in detail a power MOSFET. In particular, the electronic device 10 is of the "split-gate" type, also called "shielded-gate" type. The electronic device 10 is hereinafter more simply also referred to as MOSFET 10.

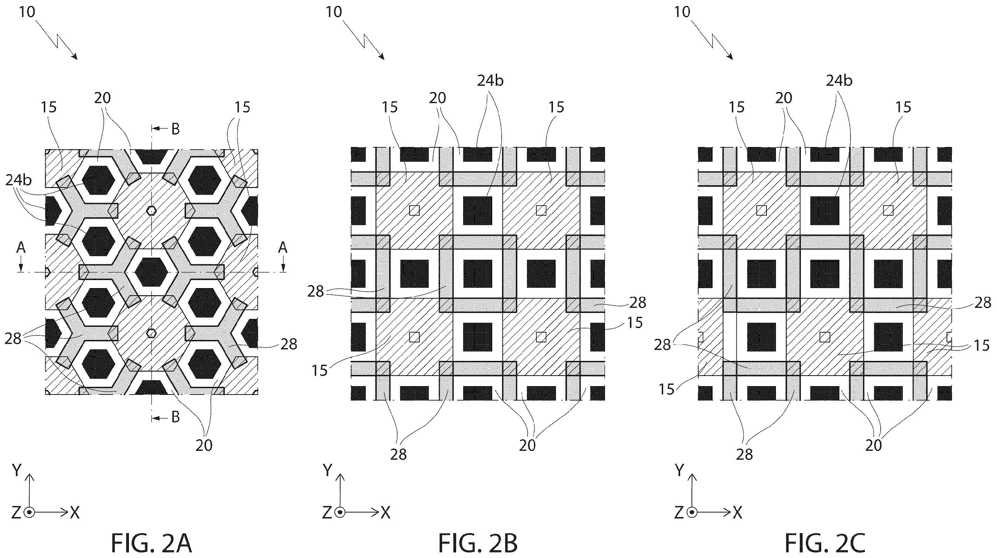

The MOSFET 10 is shown in Figure 1 in cross-section view along two different section lines. In detail, the left section in Figure 1 is taken along the section line A-A shown in Figure 2A, while the right section in Figure 1 is taken along the section line B-B shown in Figure 2A.

In detail, the MOSFET 10 comprises a semiconductor body 12 having a first and a second side (or upper side and lower side) 12a, 12b, opposite to each other along the direction of the Z axis, and a first conductivity type (hereinafter, exemplarily N).

The MOSFET 10 also comprises a plurality of trenches (or "field plate" trenches") 13 in the semiconductor body 12, at the first side 12a.

As shown in Figures 2A-2C and better described below, in top view (i.e. parallel to an XY plane defined by the axes X and Y) the trenches 13 have a closed polygonal shape (such as a hexagonal shape, square shape, etc.) and are arranged in a matrix.

With reference again to Figure 1, the MOSFET 10 comprises, for each trench 13, a respective oxide region (or insulating field plate region, also called more simply insulating region) 14 extending at the lower and lateral walls of the trench 13.

The MOSFET 10 also comprises, for each trench 13, a respective conductive gate region (more simply also gate region) 15 in the trench 13. In detail, the oxide region 14 extends below and around the gate region 15, in such a way that the gate region 15 is electrically insulated from the semiconductor body 12 by means of the oxide region 14.

The MOSFET 10 also comprises, for each trench 13, a respective field plate region 16, of electrically conductive material such as N-doped polysilicon. The field plate region (hereinafter more simply also referred to as field plate) 16 extends in the respective trench 13 and is buried within the oxide region 14, in such a way as to be electrically insulated from the conductive gate region 15 by means of a portion of the oxide region 14. A first portion 16a of the field plate 16 extends below the conductive gate region 15, without being in electrical or physical contact with the latter.

In the embodiment of Figure 1, furthermore, a second portion 16b of the field plate 16, continuous with the first portion 16a and superimposed on the latter along the direction of the Z axis, extends within the conductive gate region 15 in such a way as to traverse it along the direction of the Z axis, and is physically and electrically separated from the conductive gate region 15 through a portion of the oxide region 14.

The field plate 16 is used to reduce the electric field in the semiconductor body 12 near the trench 13 and to lower the parasitic capacity.

Each assembly of conductive gate region 15 and oxide region 14 forms a respective gate structure 22 of the MOSFET 10. Since the field plates 16 are electrically insulated from the conductive gate region 15, the gate structures 22 of the MOSFET 10 are known as "shielded-gate" or "split-gate" structures.

The MOSFET 10 further comprises, for each trench 13, a respective upper oxide region 18 extending over the trench 13 and on the conductive gate region 15. In particular, the upper oxide region 18 is not vertically superimposed (i.e. aligned along the direction of the Z axis) with the second portion 16b of the field plate 16; in other words, the upper oxide region 18 has a through opening 18' that traverses it along the direction of the Z axis and that is vertically superimposed on the second portion 16b of the field plate 16.

The MOSFET 10 further comprises, for each trench 13, a respective plurality of body regions 17 having a second conductivity type (here exemplarily of P-type). In particular, the number of body regions 17 for each trench 13 is equal to the number of sides, in top view, of the closed polygonal shape of the trench 13, such that each body region 17 is associated with a respective side of the trench 13, as better described below.

The body regions 17 are accommodated in the semiconductor body 12, laterally to the respective trench 13, and extend around the trench 13 in such a way as to surround it without solution of continuity and in such a way as to face the first side 12a of the semiconductor body 12. For example, in the cross-section of Figure 1 two body regions 17 are shown that are adjacent to opposite (along the direction of the Y axis) lateral sides of the trench 13. As better shown in Figure 2A, each body region 17 is therefore interposed, in top view and at the level of the first side 12a of the semiconductor body 12, between two trenches 13 that are first neighboring to each other in the matrix arrangement.

In detail, a portion of the oxide region 14 extends between the body regions 17 and the respective conductive gate region 15, such that the conductive gate region 15 is electrically insulated from the respective body regions 17.

The MOSFET 10 also comprises, for each trench 13, a respective plurality of source regions 20 having the first conductivity type (here exemplarily of N-type). In particular, the number of source regions 20 for each trench 13 is equal to the number of sides, in top view, of the closed polygonal shape of the trench 13, such that each source region 20 is associated with a respective side of the trench 13, as better described below.

Each source region 20 extends on a respective body region 17, at a radially external portion of the latter. In other words, each source region 20 has a through opening 20' that traverses it along the direction of the Z axis and that is vertically superimposed on a radially internal portion (or central portion) of the respective body region 17, in such a way as to expose it. In more detail, in top view, the source region 20 is of annular type and is vertically superimposed on the radially external portion of the respective body region 17, while the radially internal portion of the respective body region 17 is exposed by the through opening 20'.

Accordingly, the source regions 20 are accommodated in the semiconductor body 12, laterally to the respective trench 13, and extend around the trench 13 in such a way as to surround it without solution of continuity and in such a way as to be at the first side 12a of the semiconductor body 12. For example, in the cross-section of Figure 1 two source regions 20 are shown for each trench 13, that are adjacent to opposite (along the direction of the Y axis) lateral sides of the trench 13. As better shown in Figure 2A, each source region 20 is therefore interposed, in top view and at the level of the first side 12a of the semiconductor body 12, between two trenches 13 that are first neighboring to each other in the matrix arrangement.

In detail, the portion of the oxide region 14 that extends between the body regions 17 and the respective conductive gate region 15 also extends between the source regions 20 and the respective conductive gate region 15, such that the conductive gate region 15 is electrically insulated from the respective source regions 20.

The MOSFET 10 also comprises a source metallization 24 that extends on the upper oxide regions 18, on the body regions 17 where exposed by the through openings 20' of the source regions 20, and on the second portions 16b of the field plates 16 where exposed by the through openings 18' of the upper oxide regions 18. In greater detail, the source metallization 24 comprises a main body 24a that extends on the upper oxide regions 18, respective first metallization portions 24b that extend on the respective body regions 17 where exposed by the through openings 20' of the source regions 20, and respective second metallization portions 24c which extend on the second portions 16b of the field plates 16 where exposed by the through openings 18' of the upper oxide regions 18; in particular, the main body 24a extends with solution of continuity both with the first metallization portions 24b and with the second metallization portions 24c. Accordingly, the source metallization 24 is in direct electrical contact with the body regions 17, the source regions 20, and the field plates 16.

In use, the source metallization 24 operates as a source electrode and is biasable to a source voltage V_{S} (e.g., a ground voltage), with which the body regions 17, the source regions 20, and the field plates 16 may be biased.

Furthermore, the MOSFET 10 also comprises a drain metallization 26 that extends in contact with the semiconductor body 12 at the second side 12b.

In use, the drain metallization 26 operates as a drain electrode and is biasable to a drain voltage V_{D}, with which the semiconductor body 12 may be biased.

Furthermore, in a manner not shown, the MOSFET 10 also comprises a gate metallization that extends in contact with the gate regions 15.

In use, the gate metallization operates as a gate electrode and is biasable to a gate voltage V_{G}, with which the gate regions 15 may be biased.

In detail, Figure 1 shows an active area 11 of the MOSFET 10, which includes a plurality of cells, each defined by a respective trench 13. Externally to the active area 11, i.e. beyond an edge termination region (not shown as it is known), a lateral surface of the semiconductor body is present, for example extending substantially orthogonally to the first side. The lateral surface is formed following a dicing step of a SiC wafer wherein a plurality of MOSFETs 10 are formed. The dicing step has the function of separating a MOSFET 10 from another MOSFET 10 of the same wafer. The dicing occurs at a scribe line (not shown) of the SiC wafer from which the MOSFET 10 is obtained. This scribe line surrounds at a distance, in the XY plane, the active area 11, and for example extends externally to a protection ring (not shown) that in top view surrounds the active area 11.

With reference to Figure 1, the MOSFET 10 also comprises gate interconnections 28 that extend between the gate regions 15, in physical and electrical contact therewith, in such a way as to electrically contact them with each other.

In this manner it is possible to have the gate metallization that directly contacts only one part of the gate regions 15 (e.g., those placed at an external perimeter of the active area 11 of the MOSFET 10, in top view), while still allowing the biasing of all the gate regions 15 through the gate interconnections 28.

In particular, the gate interconnections 28 connect gate regions 15 that are arranged side-by-side to each other, in detail that are first neighboring to each other in the matrix arrangement in top view.

In detail, the MOSFET 10 has interconnection trenches 31 that extend in the semiconductor body 12 starting from the first side 12a towards the second side 12b, without reaching the latter. The interconnection trenches 31 communicate with the trenches 13, i.e. they are open on the latter, in such a way as to define an interconnection network that joins the trenches 13 to each other at the level of the first side 12a.

In greater detail, the lower surface of the interconnection trenches 31 is substantially level along the Z axis with the lower surface of the gate regions 15. The shape of the interconnection trenches 31 in top view is instead shown and better discussed below with reference to Figures 2A-2C.

The gate interconnections 28 are accommodated in the interconnection trenches 31 and are electrically insulated with respect to the semiconductor body 12, the source regions 20 and the body regions 17 through insulating interconnection portions 29, of insulating material, which also extend in the interconnection trenches 31. In particular, each insulating interconnection portion 29 extends below, and laterally to, the respective gate interconnection 28, in such a way as to be interposed between the gate interconnection 28 and the semiconductor body 12. In detail, the insulating interconnection portions 29 extend with solution of continuity with the oxide regions 14 to which they are connected.

Accordingly, each gate interconnection 28 forms, together with the respective insulating interconnection portion 29, a respective insulated interconnection structure 30 which is accommodated in the respective interconnection trench 31.

As shown in Figure 1, the gate interconnections 28 extend at the first side 12a of the semiconductor body 12, in particular level with the gate regions 15.

The gate interconnections 28 are continuous with the gate regions 15 to which they are coupled, in detail are of the same material as the gate regions 15 so as to extend with solution of continuity with respect to the latter.

In particular, the gate interconnections 28 may have a thickness, measured along the direction of the Z axis, that is about equal to the thickness of the gate regions 15.

For purely illustrative and non-limiting purposes, the gate interconnections 28 may have a thickness comprised between about 0.5 µm and about 0.7 µm and a width, measured in the XY plane in a direction orthogonal to the main extension of the gate interconnection 28, comprised between about 0.15 µm and about 0.25 µm. The length of the gate interconnections 28, measured in the XY plane along the main extension of the gate interconnection 28, depends instead in a per se obvious manner on the mutual distance between the trenches 13, as better assumable from the following Figures 2A-2C.

Similarly and again for purely illustrative and non-limiting purposes, the interconnection trenches 31 may have a thickness along the Z axis comprised between about 0.6 µm and about 0.8 µm and a width, measured in the XY plane in a direction orthogonal to the main extension of the interconnection trenches 31, comprised between about 0.25 µm and about 0.35 µm (in other words, the oxide thickness of the insulating interconnection portions 29 is about 50 nm). The length of the interconnection trenches 31, measured in the XY plane along the main extension of the interconnection trenches 31, depends instead in a per se obvious manner on the mutual distance between the trenches 13, as better assumable from the following Figures 2A-2C.

The shape and arrangement of the gate interconnections 28 may vary, as shown in Figures 2A-2C.

In detail, Figures 2A-2C show top views of respective embodiments of the MOSFET 10, considered at the level of the first side 12a of the semiconductor body 12.

In the embodiment of Figure 2A, the trenches 13, and therefore also the gate regions 15 and in general the gate structures 22, have a hexagonal shape parallel to the XY plane.

In Figure 2A, each vertex of each gate region 15 is connected to a respective gate interconnection 28, such that each gate interconnection 28 connects to each other three gate regions 15 that are arranged in a triangle in the view of Figure 2A.

In detail, each gate interconnection 28 has three arms, each with a respective first and second end opposite to each other. In each gate interconnection 28, the first ends of the three arms are joined to each other to form a joining portion of the gate interconnection 28. In top view, the three arms extend radially starting from the joining portion, in such a way as to be angularly equi-spaced from each other. The second end of each arm is connected to a respective vertex of one of the three gate regions 15 that, in the top view, surround the gate interconnection 28 considered.

In this manner, each mesa region (defined, in the top view of Figure 2A, by a respective source region 20 which also has, in the view in Figure 2A, a hexagonal shape) has two sides opposite to each other that are in contact with two sides of two respective gate structures 22 first neighboring in the matrix arrangement, and four sides that are in contact two by two with two respective insulated interconnection structures 30 (in detail, a first pair of sides adjacent to each other that are in contact with two respective arms of an insulated interconnection structure 30, and a second pair of sides adjacent to each other that are opposite to the sides of the first pair and are in contact with two respective arms of another insulated interconnection structure 30).

In other words, in Figure 2A the gate interconnections 28 are not directly coupled to each other, but are coupled to each other through the gate regions 15 in such a way as to define an interconnected network of gate regions 15 and gate interconnections 28.

In the embodiment of Figure 2B, the trenches 13, and therefore also the gate regions 15 and in general the gate structures 22, have a square shape parallel to the XY plane and are arranged in such a way as to be aligned with each other both parallel to the X axis and parallel to the Y axis.

In Figure 2B, each vertex of each gate region 15 is connected to a respective gate interconnection 28. The gate interconnections 28 are grouped in groups of four and each group defines a respective square-shaped annular closed path that connects four respective gate regions 15, that are arranged in a 2x2 configuration in the matrix considered.

In detail, each group of gate interconnections 28 comprises two gate interconnections 28 with main extension along the direction of the X axis and two gate interconnections 28 with main extension along the direction of the Y axis. In each group, the ends of the gate interconnections 28 are joined to each other by alternating horizontal gate interconnections 28 with vertical gate interconnections 28, so as to define the square-shaped annular closed path. For each group, the four respective gate regions 15 are each coupled to a respective vertex of the group of gate interconnections 28.

In other words, in Figure 2B the gate interconnections 28 of different groups are not directly coupled to each other, but are coupled to each other through the gate regions 15 in such a way as to define an interconnected network of gate regions 15 and gate interconnections 28.

In the embodiment of Figure 2C, the trenches 13, and therefore also the gate regions 15 and in general the gate structures 22, have a square shape parallel to the XY plane and are arranged in such a way as to be aligned with each other parallel to one axis of the XY plane (here exemplarily parallel to the X axis) and to be aligned with each other in an alternate manner parallel to the other axis of the XY plane (here exemplarily parallel to the Y axis). In other words, the gate regions 15 have a checkerboard arrangement, in top view.

In Figure 2C, each vertex of each gate region 15 is connected to a respective gate interconnection 28 and the gate interconnections 28 are connected to each other in such a way as to form serpentine paths (in detail, square zigzag paths) .

Each serpentine path has a main extension parallel to the X axis and extends, parallel to the Y axis, between two respective rows of gate regions 15 so as to electrically contact the gate regions 15 of these two rows with each other, in detail electrically contacting them one after the other along the serpentine path.

In detail, in each serpentine path the gate interconnections 28 comprise gate interconnections 28 with main extension along the direction of the X axis and gate interconnections 28 with main extension along the direction of the Y axis, that are alternated with each other in such a way as to define this square-type serpentine path. In detail, for each serpentine path the ends of the gate interconnections 28 that are consecutive to each other are joined and are coupled to a vertex of a respective gate region 15.

In other words, in Figure 2C the gate interconnections 28 of a same serpentine path are directly coupled to each other, while the gate interconnections 28 of serpentine paths different from each other are not directly coupled to each other but are coupled to each other through the gate regions 15, so as to define an interconnected network of gate regions 15 and gate interconnections 28.

In view of what has been described so far and returning to Figure 1, it is understood how each oxide region 14 includes a main body (or first portion) 14a that extends below the respective gate region 15 and around the respective field plate 16, a first oxide portion (or second portion) 14b that extends laterally and around the respective gate region 15 (in particular between the gate region 15 and both the semiconductor body 12 and the body region 17 and the source region 20) and a second oxide portion (or third portion) 14c that extends laterally and internally to the respective gate region 15 (in particular between the gate region 15 and both the second portion 16b of the respective field plate 16 and the respective second metallization portion 24c of the source metallization 24). In particular, in each oxide region 14 the respective main body 14a, the respective first oxide portion 14b and the respective second oxide portion 14c extend with solution of continuity between each other.

Furthermore, the insulating interconnection portions 29 extend below, and laterally to, the gate interconnections 28, insulating the gate interconnections 28 from the semiconductor body 12, the source regions 20 and the body regions 17 and allowing instead the electrical coupling thereof with the gate regions 15. In particular, the insulating interconnection portions 29 extend with solution of continuity with the oxide regions 14.

As is evident, in use the MOSFET 10 forms a vertical conduction channel, along which the charge carriers move, both at the interface between the body region 17 and the gate region 15 and at the interface between the body region 17 and the gate interconnection 28. In particular, this second contribution is absent in the currently known solutions and, adding to the first contribution, generates a significant increase in the overall channel perimeter and channel area. This significantly reduces the on-resistance of the MOSFET 10, as better discussed below.

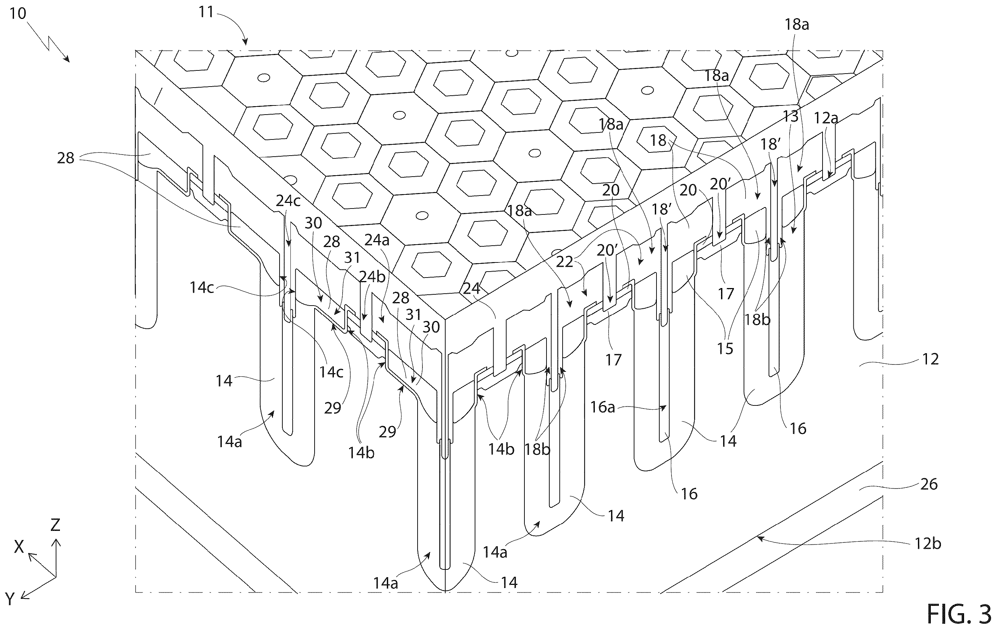

Figure 3 shows the MOSFET 10 according to a different embodiment.

The MOSFET 10 of Figure 3 is similar to the MOSFET 10 of Figure 1, so it is not described again in detail here except for highlighting its differences from the MOSFET 10 of Figure 1.

In detail, in Figure 3 each upper oxide region 18 comprises a main body 18a and an insulation portion 18b, continuous with each other. The main body 18a is, in the embodiment of Figure 3, similar to the entire upper oxide region 18 of the embodiment of Figure 1.

In Figure 3, each through opening 18' extends through the main body 18a of the upper oxide region 18, the gate region 15, and also one part of the main body 14a of the oxide region 14 (e.g., up to about 0.45 µm below a lower surface of the gate region 15). In this manner, the second metallization portions 24c contact the respective field plates 16 at a level, along the direction of the z axis, which is below the gate regions 15 and which is placed at the main body 14a of the oxide regions 14.

Furthermore, for each trench 13, the insulation portion 18b extends below the main body 18a of the upper oxide region 18, in such a way as to traverse the gate region 15 and also one part of the main body 14a of the oxide region 14. The insulation portion 18b has annular shape in top view and laterally surrounds the respective second metallization portion 24c through the entire gate region 15 and also through one part of the main body 14a of the oxide region 14.

In particular, the insulation portion 18b has a minimum width, measured parallel to the XY plane (e.g., along the direction of the Y axis), which is greater than about 50 nm, in detail it is greater than about 0.1 µm and in greater detail it is comprised between about 0.1 µm and about 0.2 µm. This minimum width substantially corresponds to the width of the circular crown that the insulation portion 18b defines in section along the XY plane, i.e. to the difference between the radius of the external circumference (in contact with the gate region 15) and the radius of the internal circumference (in contact with the second metallization portion 24c).

This minimum width of the insulation portion 18b of insulating material is greater than the similar minimum width of the second oxide portion 14c of insulating material of Figure 1. Therefore, in Figure 3 a greater electrical insulation between the source metallization 24 and the gate regions 15 may be obtained, ensuring more reliable and robust operation of the MOSFET 10, and also a lower gate-source capacity.

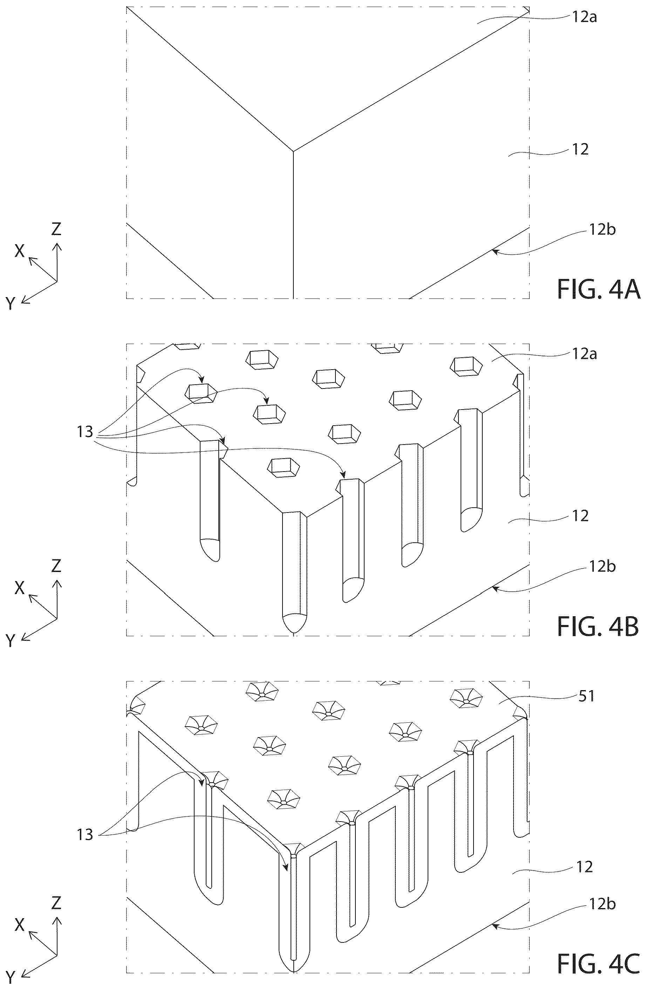

Figures 4A-4M illustrate a process for manufacturing the MOSFET 10, with specific reference to the embodiment of Figure 1.

In Figure 4A, a semiconductor substrate is provided having an optional epitaxial layer grown thereon. The substrate and the epitaxial layer form, together, the semiconductor body 12. The substrate and the epitaxial layer are, for example, of Silicon having an N-type doping.

Then, Figure 4B, the trenches 13 are formed by etching the semiconductor body 12 from the upper side 12a. The etching is performed by means of known techniques, such as RIE (Reactive Ion Etching) or DRIE (Deep Reactive Ion Etching). In the drawings, the trenches 13 have vertical lateral walls; depending on the process used to manufacture the trenches, they may also have tilted lateral walls, for example, of a truncated V-type shape in side view, or of a truncated inverted pyramid shape. The teaching of the present invention similarly applies also in the case of lateral walls of the trenches 13 not perfectly parallel to the Z axis.

Then, Figure 4C, the trenches 13 are partially filled with insulating electrical material, forming an insulating filling region 51 which is intended to form the main body 14a of the oxide regions 14. This step is performed, for example, by growing or depositing silicon oxide (SiO₂) in case the semiconductor body 12 is of Silicon; another insulating material may be grown or deposited based on the material of the semiconductor body 12.

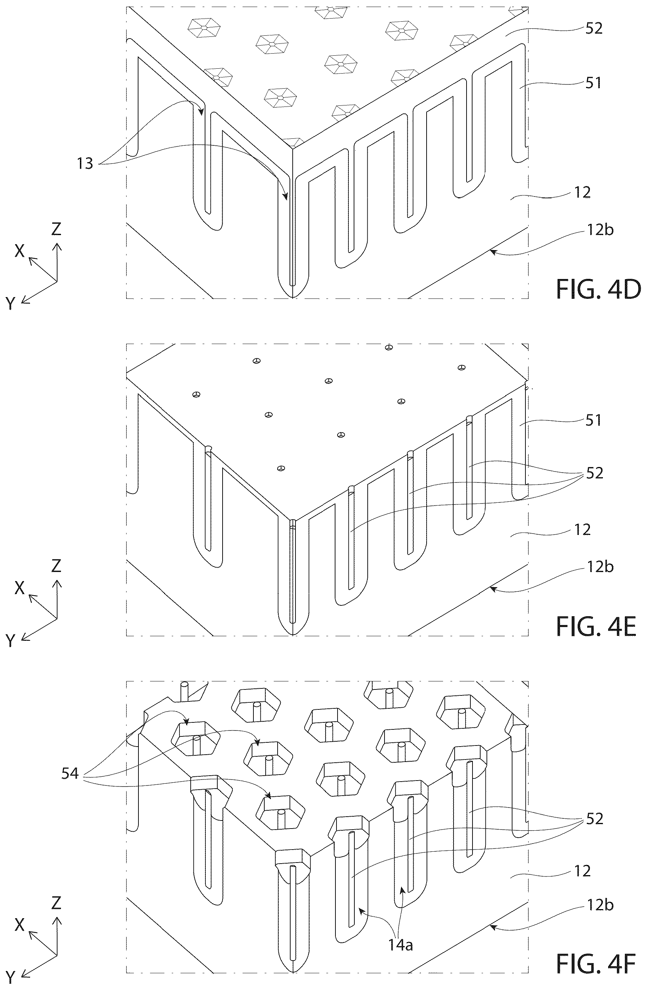

Then, Figure 4D, a step of filling the trenches 13 with conductive material is performed, forming a conductive region 52 in the trenches 13 and on the semiconductor body 12. The conductive material is for example N-doped polysilicon and completely fills the trenches 13. The conductive region 52 is intended to form the field plates 16.

Then, Figure 4E, a step for removing selective portions of the conductive region 52 is performed over the upper side 12a of the semiconductor body 12, preserving the conductive region 52 within the trenches 13.

This step may be performed by means of a CMP (Chemical-Mechanical Polishing) technique, followed by an etching step to partially etch the conductive region 52 within the trenches 13. The conductive region 52 is then recessed in each trench 13 until the conductive region 52 is below the upper side 12a. For example, the recession of the conductive regions 52 in the trenches 13 may have a depth comprised between about 50 nm and about 150 nm, measured starting from the upper side 12a.

Then, Figure 4F, the insulating filling region 51 is partially etched at the upper side 12a, to form a recess 54 in each trench 13. The etching is selective towards the material of the insulating filling region 51 and preserves the material of the conductive region 52 in the trenches 13. The portions of the insulating filling region 51 that remain following this etching form the main body 14a of the oxide regions 14.

In detail, this etching exposes one part of the lateral walls of the trenches 13, between the upper side 12a of the semiconductor body 12 and an upper side of the main body 14a of the oxide regions 14.

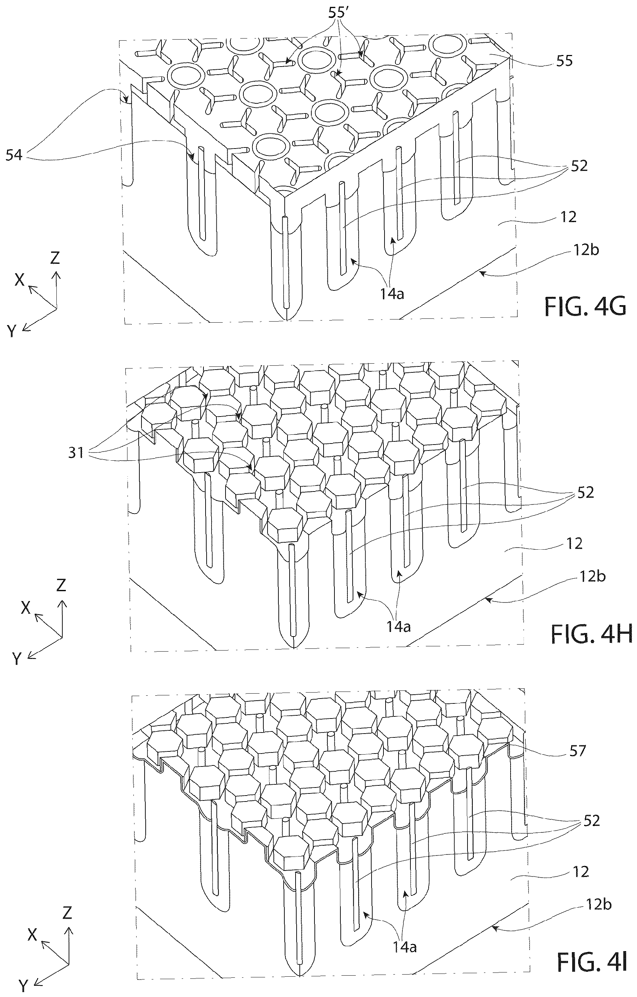

Then, Figure 4G, a mask 55 is formed on the upper side 12a of the semiconductor body 12. The mask 55, for example of polymeric material, covers the trenches 13 and the regions of the upper side 12a of the semiconductor body 12 that are not intended to accommodate the gate interconnections 28. Furthermore, the mask 55 has openings 55' that traverse the mask 55 and expose regions of the upper side 12a of the semiconductor body 12 that are intended to accommodate the gate interconnections 28. In other words, the openings 55' are vertically aligned with respect to where the gate interconnections 28 are intended to be formed; consequently, the openings 55' have a shape and arrangement entirely similar to what has been previously described with reference to the gate interconnections 28.

Then, Figure 4H, an etching step is performed to remove selective portions of the semiconductor body 12 starting from the upper side 12a. This etching step is performed through the mask 55 and forms some interconnection trenches 31 that extend in the semiconductor body 12 starting from the upper side 12a, at the regions that are exposed by the mask 55. Consequently, the interconnection trenches 31 are vertically aligned with the openings 55' and therefore have a shape and arrangement entirely similar to those of the openings 55'. In detail, the ends of the interconnection trenches 31 face the trenches 13 so as to create an interconnection network that connects the trenches 13 to each other.

The etching is interrupted when the interconnection trenches 31 have a depth similar to (in detail approximately equal to) the depth of the recesses 54. In this manner, the lower walls of the interconnection trenches 31 are substantially at the same level as the upper walls of the main bodies 14a of the oxide regions 14.

Then, Figure 4I, an oxidation step is performed (e.g. exposing the wafer to an O₂ environment), to form an insulating layer 57 on the exposed surfaces of semiconductor material.

This oxidation step allows the portion of the conductive region 52 that protrudes from, and is therefore not protected by, the insulating filling region 51 in the trenches 13 to be oxidized. This step is self-limiting and allows a buried conductive region to be formed in each trench 13. Each of these buried conductive regions forms one of the field plates 16 previously discussed. In detail, for each trench 13, the portion of the conductive region 52 that is protected by the insulating filling region 51 forms the first portion 16a of the field plate 16, while the portion of the conductive region 52 that protrudes from the insulating filling region 51 and that remains following oxidation forms the second portion 16b of the field plate 16. Furthermore, for each trench 13, the portion of the conductive region 52 that protrudes from the insulating filling region 51 and that is oxidized is intended to form the second oxide portion 14c.

This same oxidation step also causes the oxidation of the semiconductor material in the interconnection trenches 31 and on the remaining exposed parts of the upper side 12a of the semiconductor body 12, in detail on the exposed regions of the lateral walls of the trenches 13. In particular, the oxidized regions of the interconnection trenches 31 form the insulating interconnection portions 29 previously described, while the oxidized regions of the lateral walls of the trenches 13 form the first oxide portions 14b previously described.

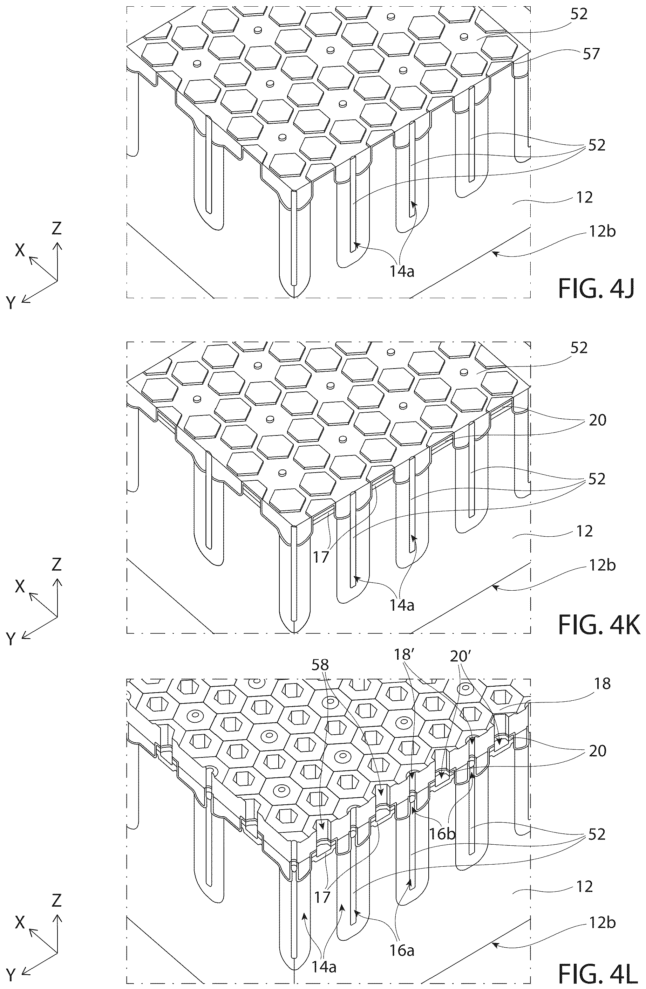

Then, Figure 4J, a formation step of the gate regions 15 and the gate interconnections 28 is performed. The gate regions 15 are formed by depositing conductive material (e.g., n-doped polysilicon) in the recesses 54, while the gate interconnections 28 are formed by depositing the same conductive material (e.g., n-doped polysilicon) in the interconnection trenches 31.

Then, Figure 4K, the body regions 17 and the source regions 20 are formed by means of known implants of P-type and N-type doping species, respectively, in the semiconductor regions between the trenches 13.

Then, Figure 4L, the upper oxide regions 18 are formed on the gate regions 15 and the gate interconnections 28.

In detail, an upper oxide layer is first formed, for example through deposition, that uniformly covers the gate regions 15, the gate interconnections 28, the source regions 20 and the field plates 16. The upper oxide layer is then etched both between the trenches 13, to form contact openings 58 wherein the first metallization portions 24b will extend, and over the field plates 16, to form the through openings 18' wherein the second metallization portions 24c will extend. Furthermore, again with reference to Figure 4L, the through openings 20' are also formed that expose the radially internal portions of the body regions 17; this is done through a further etching that is selective towards the semiconductor material and that does not etch the material of the upper oxide layer. In particular, the contact openings 58 are superimposed on the through openings 20'. Furthermore, the through openings 18' expose the upper surfaces of the second portions 16b of the field plates 16.

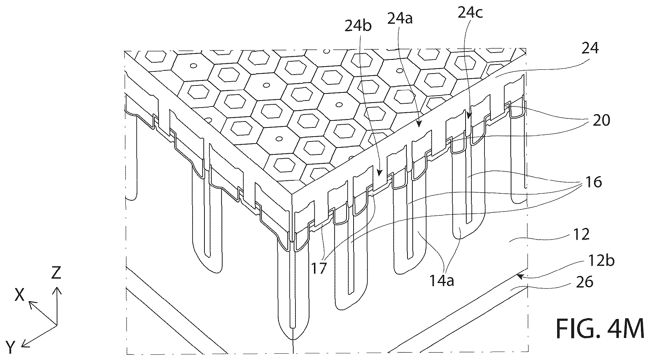

Then, Figure 4M, the source metallization 24 is formed, for example through deposition of conductive material. In detail, a layer of conductive material is deposited uniformly on the upper oxide regions 18 to form the main body 24a, in the contact openings 58 to form the first metallization portions 24b, and in the through openings 18' to form the second metallization portions 24c. Consequently, the first metallization portions 24b are in contact with the body regions 17 and the source regions 20, while the second metallization portions 24c are in contact with the field plates 16.

To complete the manufacture of the MOSFET 10, other steps may be performed that are not further described as they are not part of the present invention.

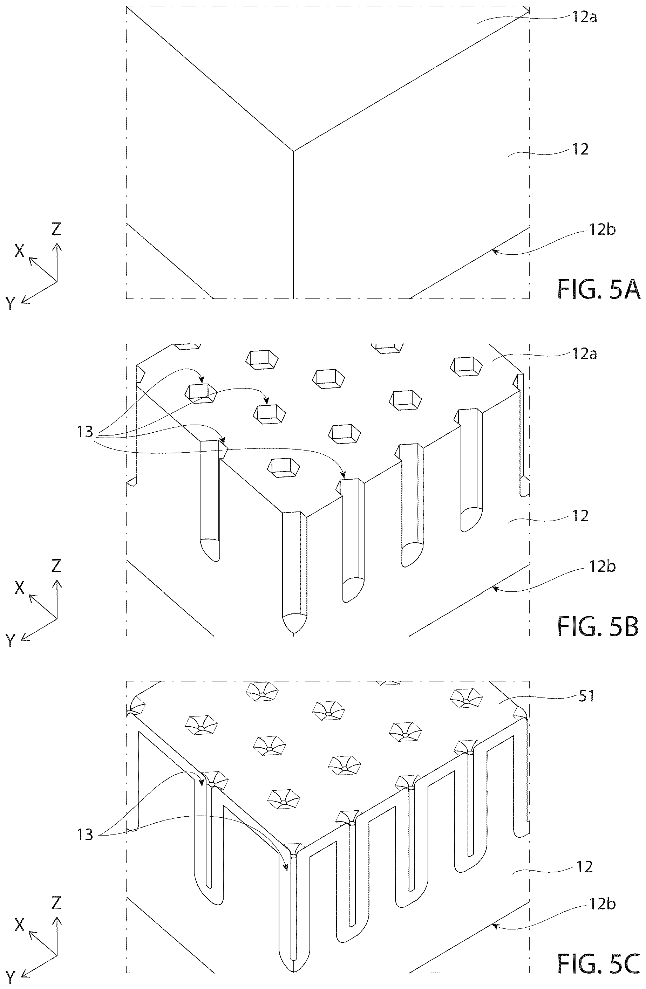

Figures 5A-5S illustrate a process for manufacturing the MOSFET 10, with specific reference to the embodiment of Figure 3.

In Figure 5A, a semiconductor substrate is provided having an optional epitaxial layer grown thereon. The substrate and the epitaxial layer form, together, the semiconductor body 12. The substrate and the epitaxial layer are for example of Silicon having an N-type doping.

Then, Figure 5B, the trenches 13 are formed by etching the semiconductor body 12 from the upper side 12a. The etching is performed by means of known techniques, such as RIE (Reactive Ion Etching) or DRIE (Deep Reactive Ion Etching). In the drawings, the trenches 13 have vertical lateral walls; depending on the process used to manufacture the trenches, they may also have tilted lateral walls, for example, of a truncated V-type shape in side view, or of a truncated inverted pyramid shape. The teaching of the present invention similarly applies also in the case of lateral walls of the trenches 13 not perfectly parallel to the Z axis.

Then, Figure 5C, the trenches 13 are partially filled with electrically insulating material, forming a first insulating filling region 51 that is intended to form the main body 14a of the oxide regions 14. This step is performed, for example, by growing or depositing silicon oxide (SiO₂) in case the semiconductor body 12 is of Silicon; another insulating material may be grown or deposited based on the material of the semiconductor body 12.

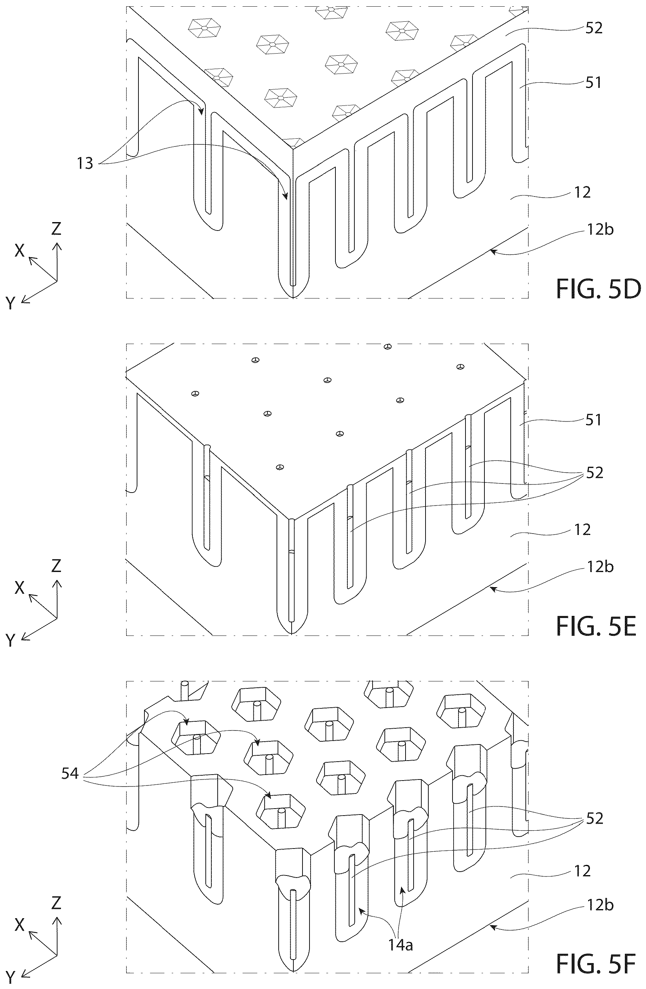

Then, Figure 5D, a step of filling the trenches 13 with conductive material is performed, forming a conductive region 52 in the trenches 13 and on the semiconductor body 12. The conductive material is for example N-doped polysilicon and completely fills the trenches 13. The conductive region 52 is intended to form the field plates 16.

Then, Figure 5E, a step for removing selective portions of the conductive region 52 over the upper side 12a of the semiconductor body 12 and, partly, within the trenches 13, is performed.

This step may be performed by means of a CMP (Chemical-Mechanical Polishing) technique, followed by an etching step to partially etch the conductive region 52 within the trenches 13. The conductive region 52 is then recessed in each trench 13 until the conductive region 52 is below the upper side 12a. In particular, the recession of the conductive regions 52 in the trenches 13 may have a depth comprised between about 0.7 µm and about 0.9 µm, measured starting from the upper side 12a; consequently, the recession of the conductive regions 52 in the trenches 13 of Figure 5E is usually greater than the similar recession of Figure 4E.

The portions of the conductive regions 52 that remain after the recession of Figure 5E form the field plates 16 previously described.

Then, Figure 5F, the first insulating filling region 51 is partially etched at the upper side 12a, to form a first recess 54 in each trench 13. The etching is selective towards the material of the first insulating filling region 51 and preserves the material of the conductive region 52 in the trenches 13. The portions of the first insulating filling region 51 that remain following this etching form the main body 14a of the oxide regions 14.

In detail, the first recesses 54 have a greater depth than the depth of the recessions of the conductive regions 52, such that the recessed conductive regions 52 protrude partly with respect to the main bodies 14a of the oxide regions 14. In particular, the first recesses 54 may have a depth comprised between about 0.6 µm and about 1.1 µm, in particular comprised between about 0.6 µm and about 0.8 µm in proximity to the semiconductor body 12 and between about 0.9 µm and about 1.1 µm at the recessed conductive regions 52, measured starting from the upper side 12a.

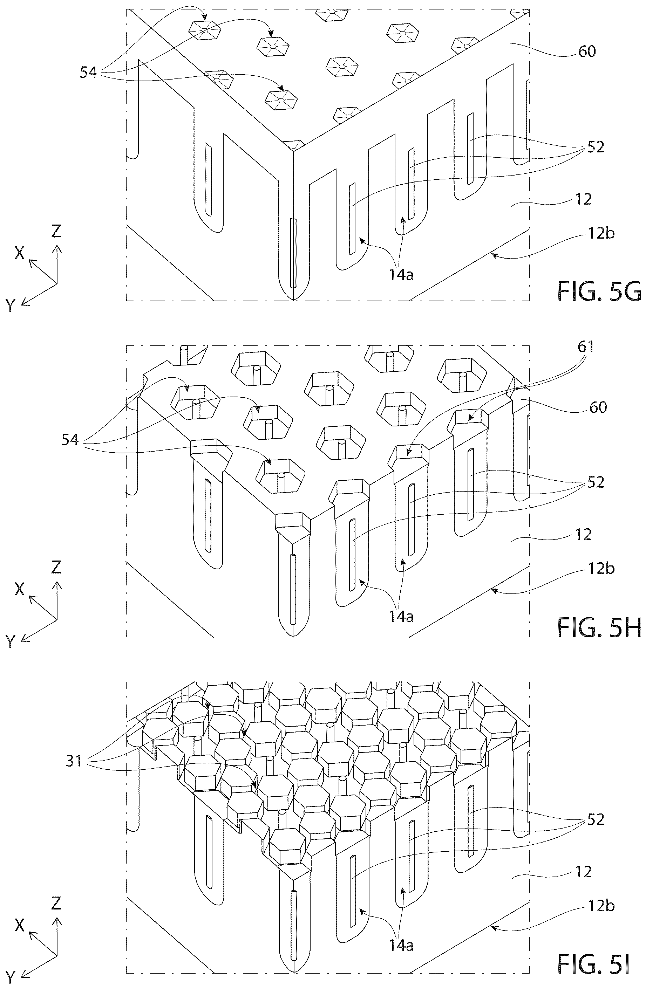

Then, Figure 5G, the first recesses 54 are filled with insulating electrical material, forming a second insulating filling region 60. This step is performed, for example, by growing or depositing silicon oxide (SiO₂) in case the semiconductor body 12 is of Silicon; another insulating material may be grown or deposited based on the material of the semiconductor body 12.

Then, Figure 5H, the second insulating filling region 60 is partially etched at the upper side 12a, to form a second recess 61 in each trench 13. The etching is selective towards the material of the first insulating filling region 51 and preserves the material of the semiconductor body 12. The portions of the second insulating filling region 60 that remain following this etching contribute to forming the main body 14a of the oxide regions 14.

In detail, the second recesses 61 have depths smaller than the depths of the recessions of the conductive regions 52, such that the recessed conductive regions 52 are covered by the portions of the second insulating filling region 60 that remain following this etching, and are therefore buried in the main bodies 14a of the oxide regions 14. In particular, the second recesses 61 may have depths comprised between about 0.6 µm and about 0.8 µm, measured starting from the upper side 12a, i.e. they may have a depth similar to that of the recesses 54 of Figure 4F.

Consequently, this etching exposes one part of the lateral walls of the trenches 13, between the upper side 12a of the semiconductor body 12 and an upper side of the main body 14a of the oxide regions 14.

Then, Figure 5I, the interconnection trenches 31 are formed in a manner entirely similar to what has been previously described with reference to Figures 4G and 4H and therefore not described again in detail. In particular, the interconnection trenches 31 have a depth substantially equal to the depth of the second recesses 61, so that the lower walls of the interconnection trenches 31 are substantially level with the upper walls of the portions of the second insulating filling region 60 that remain following the etching of Figure 5H.

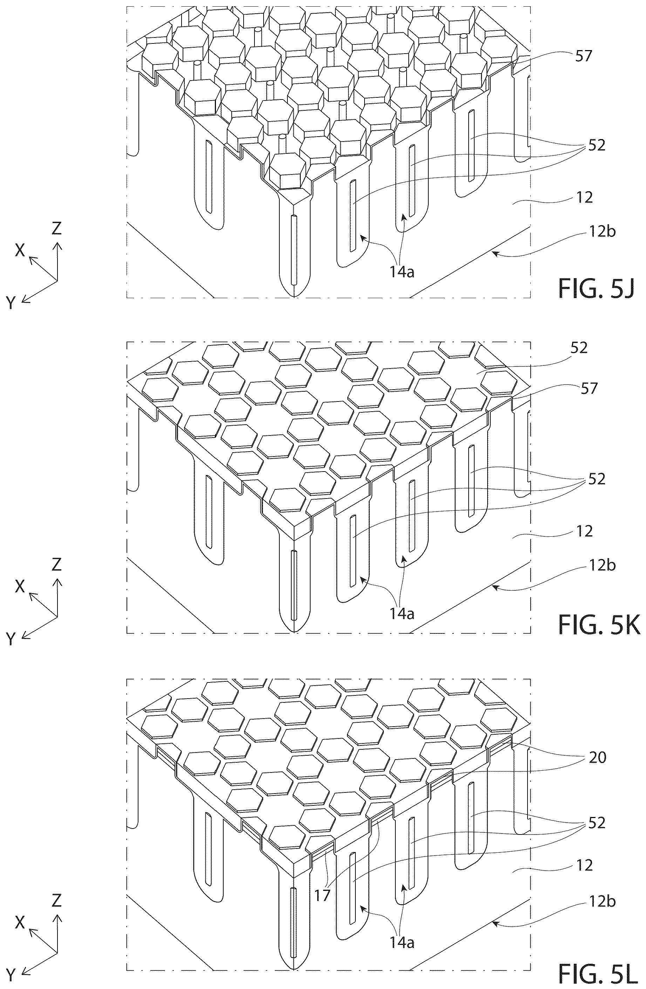

Then, Figure 5J, an oxidation step is performed (e.g. exposing the wafer to an O₂ environment), to form an insulating layer 57 on the exposed surfaces of semiconductor material.

This oxidation step causes the oxidation of the semiconductor material in the interconnection trenches 31 and on the remaining exposed parts of the upper side 12a of the semiconductor body 12, in detail on the exposed regions of the lateral walls of the trenches 13. In particular, the oxidized regions of the interconnection trenches 31 form the insulating interconnection portions 29 previously described, while the oxidized regions of the lateral walls of the trenches 13 form the first oxide portions 14b previously described.

Then, Figure 5K, a formation step of the gate regions 15 and the gate interconnects 28 is performed. The gate regions 15 are formed by depositing conductive material (e.g., n-doped polysilicon) in the second recesses 61, while the gate interconnections 28 are formed by depositing the same conductive material (e.g., n-doped polysilicon) in the interconnection trenches 31.

Then, Figure 5L, the body regions 17 and the source regions 20 are formed by means of known implants of P-type and N-type doping species, respectively, in the semiconductor regions between the trenches 13.

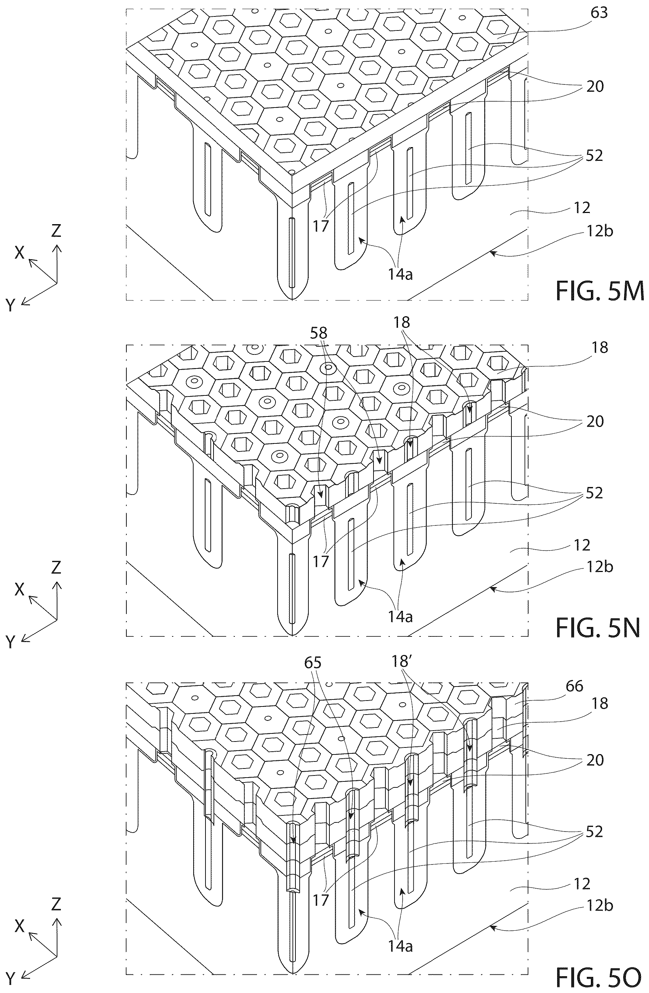

Then, Figure 5M, an upper oxide layer 63 is formed, for example through deposition, that uniformly covers the gate regions 15, the gate interconnections 28 and the source regions 20.

Then, Figure 5N, the upper oxide regions 18 are formed on the gate regions 15 and on the gate interconnections 28, starting from the upper oxide layer 63. In detail, the upper oxide layer 63 is etched both between the trenches 13, to form first contact openings 58 wherein the first metallization portions 24b will extend, and over the field plates 16, to form the through openings 18' wherein the second metallization portions 24c will extend. In detail, the through openings 18' here expose parts of the gate regions 15 that extend on the field plates 16.

Then, Figure 5O, first field plate contact trenches 65 are formed that are vertically aligned with the through openings 18' and that extend through the gate regions 15 and through the second insulating filling regions 60, up to exposing the upper surface of the field plates 16.

In detail, this occurs through a sequence of selective etchings that selectively recess first the material of the gate regions 15 and then the material of the second insulating filling regions 60. These etchings are for example performed through a mask 66 with openings that are superimposed on the through openings 18', which is removed after the etchings.

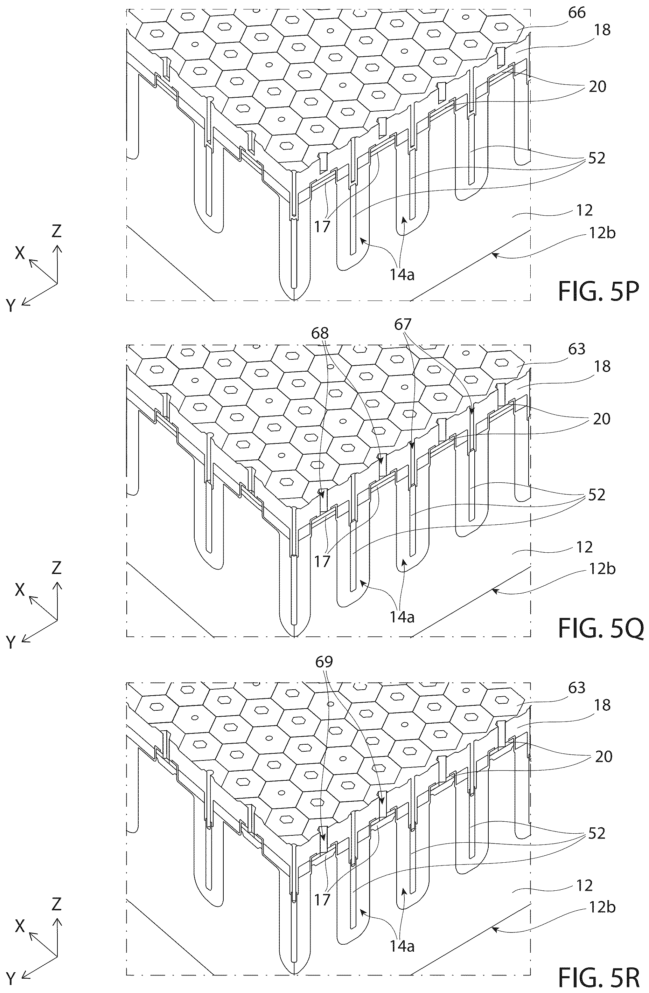

Then, Figure 5P, an oxide deposition step (e.g. through TEOS deposition) is performed, to cover the exposed surfaces of semiconductor material with oxide. In detail, this oxidation step cover with oxide the semiconductor material of the gate regions 15 and the field plates 16, where exposed by the first field plate contact trenches 65, and also the semiconductor material of the source regions 20, where exposed by the first contact openings 58. In other words, the upper oxide regions 18 operate as a mask for this deposition step. In particular, the oxide layer on the semiconductor material of the gate regions 15 at the first field plate contact trenches 65 is intended to form the insulation portions 18b previously described.

Then, Figure 5Q, second field plate contact trenches 67 are formed that extend through the oxide portions on the field plates 16 that have been formed in the deposition of Figure 5P, up to exposing the upper surface of the field plates 16. Furthermore, second contact openings 68 are formed that extend through the oxide portions on the source regions 20 that have been formed in the deposition of Figure 5P, up to exposing the upper surface of the source regions 20.

In detail, this occurs through a selective etching that recesses the oxide material without etching the material of the field plates 16 and the source regions 20.

Then, Figure 5R, third contact openings 69 are formed that are vertically aligned with the second contact openings 68 and that extend through the source regions 20 up to exposing the upper surface of the radially internal portions of the body regions 17.

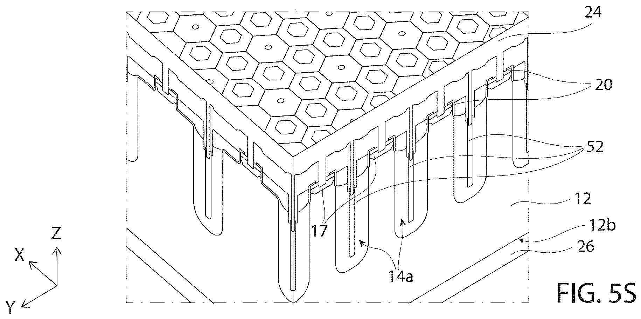

Then, Figure 5S, the source metallization 24 is formed, for example through deposition of conductive material. In detail, a layer of conductive material is uniformly deposited on the upper oxide regions 18 to form the main body 24a, in the third contact openings 69 to form the first metallization portions 24b, and in the field plate contact trenches 67 to form the second metallization portions 24c. Accordingly, the first metallization portions 24b are in contact with the body regions 17 and the source regions 20, while the second metallization portions 24c are in contact with the field plates 16.

To complete the manufacturing of the MOSFET 10, other steps may be performed that are not further described as they are not part of the present invention.

In detail, the manufacturing process of Figures 5A-5S allows, compared to the solution of Figures 4A-4M, a more accurate control of the insulation of the gate regions 15 with respect to the source metallization 24 at the point where the latter contacts the field plates 16 and also reduces the gate-source capacity by virtue of the greater thickness of the insulation portions 18b.

From an examination of the characteristics of the invention made according to the present invention, the advantages that it affords are evident.

In particular, the MOSFET 10 of the split-gate type allows the on-resistance to be reduced without having to resize the diffusion process or increase the lithographic resolution, thus saving costs and difficulties during the manufacturing step.

In particular, this occurs by virtue of a significant increase in the channel perimeter (e.g., about 130% more), obtained through the use of the gate interconnections 28, and a significant increase in the conduction area (e.g., about 60% more), obtained through the use of the trenches 13 being cellular-matrix shaped instead of strip-shaped.

Finally, it is clear that modifications and variations may be made to the invention described and illustrated here without thereby departing from the scope of the present invention, as defined in the attached claims.

For example, the different embodiments described may be combined with each other to provide further solutions.

Furthermore, the present solution may be applied to any type of trench-gate vertical conduction device, such as, but not limited to, a VDMOS transistor, or a trench-based power MOSFET device.

Furthermore, other shapes and arrangements may be used, as an alternative to what has been exemplarily shown in Figures 2A-2C. For example, the square shapes of Figures 2A-2C may be replaced by more generic quadrangular shapes, such as for example rectangular or rhomboid shapes.

## Claims

1. An electronic device (10), comprising:
a semiconductor body (12) having a first and a second side (12a, 12b) opposite to each other along a first axis (Z);
a plurality of trenches (13) extending within the semiconductor body (12) from the first side (12a) towards the second side (12b) and terminating within the semiconductor body (12);
a respective insulating region (14) in each of said trenches (13), covering the lower and lateral walls of the respective trench (13);
a respective conductive gate region (15) in each of said trenches (13) on a respective first portion (14a) of the respective insulating region (14), each conductive gate region (15) being of conductive material and being electrically insulated from the semiconductor body (12) by means of a respective second portion (14b) of the respective insulating region (14);
a respective field plate region (16) in each of said trenches (13), each field plate region (16) being buried in the respective first portion (14a) of the respective insulating region (14) and being electrically insulated from the respective conductive gate region (15) and the semiconductor body (12) by means of a respective third portion (14c) of the respective insulating region (14);
a plurality of gate interconnections (28) extending within the semiconductor body (12) from the first side (12a) towards the second side (12b), laterally to the trenches (13), and terminating within the semiconductor body (12), the gate interconnections (28) being of conductive material, being electrically insulated from the semiconductor body (12) and being electrically connected to the conductive gate regions (15) in such a way as to electrically interconnect the conductive gate regions (15) with each other.

2. The electronic device according to claim 1, further comprising a plurality of interconnection trenches (31), each interconnection trench (31) extending within the semiconductor body (12) from the first side (12a) towards the second side (12b) and terminating within the semiconductor body (12),
wherein the interconnection trenches (31) are interposed, orthogonally to the first axis (Z), between the trenches (13) and are communicating with the trenches (13),
wherein the gate interconnections (28) extend within the interconnection trenches (31) in such a way as to electrically contact the conductive gate regions (15) with each other,
the electronic device (10) further comprising insulating interconnection portions (29), of insulating material, which extend in the interconnection trenches (31) in such a way as to be interposed between the gate interconnections (28) and the semiconductor body (12) to electrically insulate the gate interconnections (28) from the semiconductor body (12).

3. The electronic device according to claim 1 o 2, wherein, orthogonally to the first axis (Z), the trenches (13) have a closed polygonal shape and a matrix arrangement.

4. The electronic device according to claim 3, wherein the trenches (13) and the conductive gate regions (15) have a hexagonal shape orthogonally to the first axis (Z),
wherein each gate interconnection (28) connects to each other three respective gate regions (15) that are first neighboring to each other in the matrix arrangement,
wherein each gate interconnection (28) has three respective arms, each arm having a respective first and a respective second end opposite to each other with respect to the direction of main extension of the arm, the first ends of the arms of each gate interconnection (28) being joined to each other to form a joining portion of the gate interconnection (28), starting from which the respective three arms extend radially in such a way as to be angularly equi-spaced from each other orthogonally to the first axis (Z),
wherein the second end of each arm of each gate interconnection (28) is coupled to a respective vertex of a respective one of the three gate regions (15) that, in the matrix arrangement, surround the respective gate interconnection (28).

5. The electronic device according to claim 3, wherein the trenches (13) are aligned with each other, in the matrix arrangement, both along a second axis (X) orthogonal to the first axis (Z) and along a third axis (Y) orthogonal to both the first axis (Z) and the second axis (X),
wherein the trenches (13) and the conductive gate regions (15) have a quadrilateral shape, in particular a square shape, orthogonally to the first axis (Z),
wherein the gate interconnections (28) are grouped in groups each of four respective gate interconnections (28), each group of gate interconnections (28) connecting to each other four respective gate regions (15) that are first neighboring to each other in the matrix arrangement,
wherein each group of gate interconnections (28) forms a conductive path that, orthogonally to the first axis (Z), is of an annular type and has a quadrilateral shape, in particular a square shape,
wherein each vertex of the quadrilateral shape of each conductive path is connected to a respective vertex of a respective one of the four gate regions (15) that, in the matrix arrangement, surround the respective group of gate interconnections (28).

6. The electronic device according to claim 3, wherein the trenches (13), in the matrix arrangement, are aligned with each other along a second axis (X) orthogonal to the first axis (Z) and are aligned with each other alternately along a third axis (Y) orthogonal to both the first axis (Z) and the second axis (X),
wherein the trenches (13) and the conductive gate regions (15) have a quadrilateral shape, in particular a square shape, orthogonally to the first axis (Z),
wherein the gate interconnections (28) are grouped to form serpentine paths of gate interconnections (28), each serpentine path having a main extension along the direction of the second axis (X) and extending, along the direction of the third axis (Y), between two respective rows of conductive gate regions (15), each row comprising respective conductive gate regions (15) that are aligned with each other along the direction of the second axis (X),
each serpentine path being coupled to vertices of the respective conductive gate regions (15) in such a way as to couple to each other, in succession, the conductive gate regions (15) of said two respective rows having the serpentine path interposed therebetween.

7. The electronic device according to any of the preceding claims, further comprising a gate metallization that is located at the first side (12a) of the semiconductor body (12) and is directly electrically connected to one part of the conductive gate regions (15).

8. The electronic device according to any of the preceding claims, wherein the semiconductor body (12) has a first conductivity type (N), the electronic device further comprising:
a plurality of body regions (17) extending at the first side (12a) between the trenches (13), the body regions (17) having a second conductivity type (P) opposite to the first conductivity type (N);
a plurality of source regions (20), each in a respective one of the body regions (17);
a source metallization (24) that is located at the first side (12a) of the semiconductor body (12) and is electrically connected to the source regions (20) and the field plate regions (16); and
a drain metallization (26) that is located at the second side (12b) of the semiconductor body (12).

9. The electronic device according to claims 3 and 8, wherein the number of body regions (17) and of the respective source regions (20) for each trench (13) is equal to the number of sides, in top view, of the closed polygonal shape of the trench (13), such that each body region (17) is associated with a respective side of the trench (13),
wherein the gate interconnections (28) are physically and electrically connected to the respective conductive gate regions (15),
wherein each gate interconnection (28) connects a least one vertex of one of the conductive gate regions (15) to at least one vertex of an adjacent conductive gate region (15) of the conductive gate regions (15) and to another vertex of another adjacent conductive gate region (15) of the conductive gate regions (15).

10. The electronic device according to claim 8 or 9, wherein the source metallization (24) has a respective metallization portion (24c) for each trench (13), each metallization portion (24c) extending through the respective conductive gate region (15) along the direction of the first axis (Z) up to reaching the respective field plate region (16),
wherein each metallization portion (24c) is electrically insulated with respect to the respective conductive gate region (15) through a respective insulation portion (18b), of insulating material,
wherein, orthogonally to the first axis (Z), each insulation portion (18b) has an annular shape, surrounds the respective metallization portion (24c) and is interposed between the respective metallization portion (24c) and the respective conductive gate region (15) in such a way as to space, orthogonally to the first axis (Z), the respective metallization portion (24c) and the respective conductive gate region (15) by at least a minimum distance equal to 50 nm.

11. The electronic device according to any of the preceding claims, being of the vertical conduction type.

12. A process for manufacturing an electronic device (10), comprising the steps of:
forming a plurality of trenches (13) within a semiconductor body (12), the semiconductor body (12) having a first and a second side (12a, 12b) opposite to each other along a first axis (Z), the trenches (13) extending from the first side (12a) towards the second side (12b) and terminating within the semiconductor body (12);
forming a respective insulating region (14) in each of said trenches (13), covering the lower and lateral walls of the respective trench (13);
forming a respective field plate region (16) in each of said trenches (13), each field plate region (16) being buried in a respective first portion (14a) of the respective insulating region (14) and being electrically insulated from the semiconductor body (12) by means of a respective third portion (14c) of the respective insulating region (14);
forming a respective conductive gate region (15) in each of said trenches (13) on the respective first portion (14a) of the respective insulating region (14), each conductive gate region (15) being of conductive material and being electrically insulated from the semiconductor body (12) and the respective field plate region (16) by means of a respective second portion (14b) of the respective insulating region (14);
forming a plurality of gate interconnections (28) extending within the semiconductor body (12) from the first side (12a) towards the second side (12b), laterally to the trenches (13), and terminating within the semiconductor body (12), the gate interconnections (28) being of conductive material, being electrically insulated from the semiconductor body (12) and being electrically connected to the conductive gate regions (15) in such a way as to electrically interconnect the conductive gate regions (15) with each other.

13. The manufacturing process according to claim 12, further comprising, after the step of forming the field plate regions (16), the steps of:
partially etching a respective insulating filling region (51) in each trench (13) at the first side (12a), to form a recess (54) in each trench (13) and define a main body (14a) of each insulating region (14);
selectively removing portions of the semiconductor body (12) starting from the first side (12a) to form interconnection trenches (31), each interconnection trench (31) extending within the semiconductor body (12) from the first side (12a) towards the second side (12b) and terminating within the semiconductor body (12), the interconnection trenches (31) being interposed, orthogonally to the first axis (Z), between the trenches (13) and being communicating with the trenches (13); and
forming an insulating layer (57) in the interconnection trenches (31) and the recesses (54), the portions of the insulating layer (57) present in the interconnection trenches (31) defining insulating interconnection portions (29) that extend in the interconnection trenches (31), and
wherein the step of forming the conductive gate regions (15) and the step of forming the gate interconnections (28) are performed simultaneously by depositing conductive material in the recesses (54) and in the interconnection trenches (31), respectively, such that the insulating interconnection portions (29) are interposed between the gate interconnections (28) and the semiconductor body (12) in the interconnection trenches (31).

14. The manufacturing process according to claim 12, further comprising, after the step of forming the field plate regions (16), the steps of:
partially removing a respective insulating filling region (51) in each trench (13) at the first side (12a), to form a first recess (54) in each trench (13), the field plate regions (16) protruding partly into said first recesses (54);
forming a second insulating filling region (60) in the trenches (13) at the first side (12a);
partially removing the second insulating filling region (60) at the first side (12a), to form a second recess (61) in each trench (13) such as to leave the field plate regions (16) covered;
selectively removing portions of the semiconductor body (12) starting from the first side (12a) to form interconnection trenches (31), each interconnection trench (31) extending within the semiconductor body (12) from the first side (12a) towards the second side (12b) and terminating within the semiconductor body (12), the interconnection trenches (31) being interposed, orthogonally to the first axis (Z), between the trenches (13) and being communicating with the trenches (13);
forming an insulating layer (57) in the interconnection trenches (31) and the second recesses (61), the portions of the insulating layer (57) present in the interconnection trenches (31) defining insulating interconnection portions (29) that extend in the interconnection trenches (31), and
wherein the step of forming the conductive gate regions (15) and the step of forming the gate interconnections (28) are performed simultaneously by depositing conductive material in the second recesses (61) and in the interconnection trenches (31), respectively, such that the insulating interconnection portions (29) are interposed between the gate interconnections (28) and the semiconductor body (12) in the interconnection trenches (31).

15. The manufacturing process according to claim 14, further comprising, after the step of forming the conductive gate regions (15) and the step of forming the gate interconnections (28), the steps of:
forming an upper oxide layer (63) on the gate regions (15) and on the gate interconnections (28);
partially removing the upper oxide layer (63) to form through openings (18') that extend through the upper oxide layer (63) up to the conductive gate regions (15) and are aligned along the direction of the first axis (Z) with the field plate regions (16);
forming first field plate contact trenches (65) through the through openings (18'), the first field plate contact trenches (65) extending through the gate regions (15) and the second insulating filling regions (60) up to exposing the field plate regions (16);
depositing an oxide layer in the first field plate contact trenches (65), the oxide layer comprising portions present on the field plate regions (16), and insulation portions (18b) which, orthogonally to the first axis (Z), have annular shape and each cover a wall of the respective gate region (15) where exposed by the respective first field plate contact trench (65);
forming second field plate contact trenches (67) through the first field plate contact trenches (65), the second field plate contact trenches (67) extending through the oxide layer portions present on the field plate regions (16) up to exposing the field plate regions (16); and
forming a source metallization (24) with metallization portions (24c) that extend in the field plate contact trenches (67) in such a way as to be in contact with the field plate regions (16),
wherein each metallization portion (24c) is electrically insulated with respect to the respective conductive gate region (15) through the respective insulation portion (18b), of insulating material, and
wherein, orthogonally to the first axis (Z), each insulation portion (18b) surrounds the respective metallization portion (24c) and is interposed between the respective metallization portion (24c) and the respective conductive gate region (15) in such a way as to space, orthogonally to the first axis (Z), the respective metallization portion (24c) and the respective conductive gate region (15) by at least a minimum distance equal to 50 nm.
